(19) Europäisches Patentamt
European Patent Office
Office européen des brevets

(11) **EP 3 396 830 B1**

(12) # EUROPEAN PATENT SPECIFICATION

(45) Date of publication and mention of the grant of the patent:
**02.03.2022 Bulletin 2022/09**

(21) Application number: **18151815.0**

(22) Date of filing: **16.01.2018**

(51) International Patent Classification (IPC):
***H02M 1/08*** *(2006.01)* ***H02M 7/5387*** *(2007.01)*

(52) Cooperative Patent Classification (CPC):
**H02M 1/08; H02M 7/5387**

(54) **POWER CONVERSION APPARATUS AND AIR CONDITIONER INCLUDING THE SAME**

LEISTUNGSUMWANDLUNGSVORRICHTUNG UND KLIMAANLAGE DAMIT

APPAREIL DE CONVERSION DE PUISSANCE ET CLIMATISEUR LE COMPRENANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.04.2017 KR 20170052476**

(43) Date of publication of application:
**31.10.2018 Bulletin 2018/44**

(73) Proprietor: **LG Electronics Inc.**
**Seoul 07336 (KR)**

(72) Inventors:
- **NAM, Hansung**
  **08592 Seoul (KR)**
- **LEE, Wonwoo**
  **08592 Seoul (KR)**

(74) Representative: **Vossius & Partner**
**Patentanwälte Rechtsanwälte mbB**
**Siebertstrasse 3**
**81675 München (DE)**

(56) References cited:
**WO-A1-2013/159281**
**JP-A- 2004 023 880**
**JP-A- 2005 051 959**
**JP-A- 2014 036 539**
**US-A- 5 694 065**
**US-A1- 2007 273 350**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

The present invention relates to a power conversion apparatus and, more particularly, to a power conversion apparatus capable of improving an electromagnetic interference (EMI) characteristic and an air conditioner including the same.

Generally, a compressor of an air conditioner uses a motor as a power source. Alternating current (AC) power is supplied to the motor from a power conversion apparatus.

The power conversion apparatus is normally known as including a rectifier, a power factor controller, and an inverter.

A commercial AC voltage output from a commercial power source is rectified by the rectifier. The voltage rectified by the rectifier is supplied to the inverter. The inverter generates AC power for driving the motor, using the voltage output from the rectifier.

In some cases, a DC-DC converter for improving a power factor may be provided between the rectifier and the inverter.

A collector current, which is a current applied to a switching element, is raised with a predetermined slope by an inductor component of the motor but includes noise before the switching element is fully switched on. Such noise is caused by switching noise of the switching element.

In this case, such switching noise occurring in each phase may overlap and may be amplified.

This switching noise may deteriorate an electromagnetic interference (EMI) characteristic.

While the EMI characteristic may be improved by changing a switching frequency or according to some circuit configurations, problems such as complexity and increase in cost arise.

Accordingly, a method capable of improving the EMI characteristic by a simple configuration even without changing a switching frequency is needed.

JP 2014-036539 A describes an inverter device and a switching time correction method therefor preventing an increase in switching noise generated between a power supply and GND.

JP 2005-051959 A discloses a noise reduction method and circuit for a power converter.

Accordingly, the present invention is directed to a power conversion apparatus and an air conditioner including the same that substantially obviate one or more problems due to limitations and disadvantages of the related art.

An object of the present invention is to provide a power conversion apparatus capable of improving an EMI noise characteristic by delaying an on/off time of a switching element of each phase and thus avoiding overlapping of initially damped noise, and an air conditioner including the same.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

These objects and other advantages are achieved by the invention as defined by claim 1. The invention includes an inverter including a plurality of switching elements corresponding to three phases, a gate driver configured to drive the switching elements of the inverter, and a noise reducer connected to the gate driver and configured to set switching noise occurrence times caused by the switching elements in the respective phases to be different.

The noise reducer includes resistor-capacitor (RC) filters connected to the respective phases and at least two of the RC filters have different time constant values.

The time constant values are sequentially changed.

The time constant values may be sequentially increased from a reference value.

The power conversion apparatus may further include a controller configured to transmit a control signal to the gate driver and the noise reducer may be connected between the gate driver and the controller.

The noise reducer may include a filter circuit configured to reduce noise of the control signal transmitted to the gate driver.

The noise reducer may set on times of the switching elements to be different.

The noise reducer may set the switching noise occurrence times to be sequentially delayed in the respective phases.

The delayed times may be shorter than switching times of the switching elements.

The plurality of switching elements includes upper switching elements and lower switching elements.

The RC filters connected to the upper switching elements of the respective phases and the RC filters connected to the lower switching elements of the respective phases have a common value.

The noise reducer is connected to either one of the upper switching elements or the lower switching elements.

It is to be understood that both the foregoing general description and the following detailed description of the present invention are exemplary and explanatory and are intended to provide further explanation of the invention as claimed.

## BRIEF DESCRIPTION OF THE DRAWINGS

The accompanying drawings, which are included to provide a further understanding of the invention and are incorporated in and constitute a part of this application, illustrate embodiments of the invention and together with the description serve to explain the principle of the invention. In the drawings:

FIG. 1 is a block diagram of a power conversion apparatus according to an embodiment of the present invention;
FIG. 2 is a circuit diagram of the power conversion apparatus according to an embodiment of the present invention;
FIG. 3 is a circuit diagram illustrating the power conversion apparatus according to an embodiment of the present invention in detail;
FIG. 4 is a waveform chart illustrating current when a normal filter circuit is applied;
FIG. 5 is a waveform chart illustrating current when a noise reducer of the present invention is applied;
FIG. 6 is a waveform chart illustrating current and voltage waveforms of a switching element;
FIG. 7 is a waveform chart illustrating a process of designing a time constant of a noise reducer of the present invention;
FIG. 8 is a waveform chart illustrating a phase current caused by an inverter and an enlarged view thereof; and
FIG. 9 is a waveform chart illustrating actual switching noise of a phase current.

## DETAILED DESCRIPTION OF THE INVENTION

Reference will now be made in detail to the preferred embodiments of the present invention, examples of which are illustrated in the accompanying drawings. Wherever possible, the same reference numbers will be used throughout the drawings to refer to the same or like parts.

While the present invention permits various modifications and alternative forms, specific embodiments thereof are shown by way of example in the drawings, and will herein be described in detail. It should be understood, however, that there is no intent to limit the present invention to the particular forms disclosed, but on the contrary, the present invention is to cover all modifications, equivalents, and alternatives falling within the scope of the appended claims.

It will be understood that, when an element such as a layer or a substrate is referred to as being "on" another element, it can be directly on the other element or include intervening elements that are present between the element and the other element.

It will be understood that, although the terms first, second, etc. may be used herein to describe various elements, components, regions, layers, and/or areas, these elements, components, regions, layers, and/or areas should not be limited by these terms. These terms are only used to distinguish one element, component, region, layer, or area from another element, component, region, layer, or area.

FIG. 1 is a block diagram of a power conversion apparatus according to an embodiment of the present invention and FIG. 2 is a circuit diagram of the power conversion apparatus according to an embodiment of the present invention.

Referring to FIGs. 1 and 2, a power conversion apparatus 100 may include a rectifier 110 for rectifying a voltage input from an AC power supply 10, a converter 120 for boosting or bucking a DC voltage rectified by the rectifier 110 or controlling a power factor, a converter controller 130 for controlling the converter 120, an inverter 140 for outputting a three-phase AC current, an inverter controller 150 for controlling the inverter 140, and a DC-link capacitor C connected between the converter 120 and the inverter 140.

The inverter 140 outputs the three-phase AC current and this output current is supplied to a motor 200. Herein, the motor 200 may be a compressor motor for driving an air conditioner. Hereinafter, a description will be given by taking a compressor motor for driving the air conditioner as an example of the motor 200 and a motor driving apparatus for driving the compressor motor as an example of the power conversion apparatus 100.

However, the motor 200 is not limited to the compressor motor and may be used as an AC motor used in various applications using a frequency-variable AC voltage, such as a refrigerator, a washing machine, an electric car, an automobile, and a cleaner.

Meanwhile, the motor driving apparatus 100 may further include a DC terminal voltage detector B, an input voltage detector A, an input current detector D, and an output current detector E.

The motor driving apparatus 100 receives AC power from a system, converts the power, and supplies the converted power to the motor 200.

The converter 120 converts power input from the AC power supply 10 into DC power. The converter 120 may use a DC-DC converter operating as a power factor control (PFC) unit. The DC-DC converter may use a boost converter. In some cases, the converter 120 may be used as a concept including the rectifier 110. Hereinafter, the boost converter will be described as an example of the converter 120.

The rectifier 110 rectifies power input from the AC power supply 10 and outputs the rectified power to the converter 120. To this end, the rectifier 110 may use a full-wave rectification circuit using bridge diodes.

In this way, in the process of boosting and smoothing a voltage signal rectified by the rectifier 110, the converter 120 may perform an operation of improving a power factor.

The converter 120 may include an inductor L1 connected to the rectifier 110, a switching element Q1 connected to the inductor L1, and a diode D1 connected between the switching element Q1 and the DC-link capacitor C.

The boost converter 120 may obtain an output voltage higher than an input voltage. If the switching element Q1 is turned on, the diode D1 is turned off and energy is stored in the inductor L1. In addition, electric charges stored in the DC-link the capacitor C are discharged to generate an output voltage at an output terminal.

If the switching element Q1 is turned off, energy which has been stored in the inductor L1 while the switching element Q1 is turned on is added and then transmitted to the output terminal.

Herein, the switching element Q1 may perform a switching operation by a pulse width modulation (PWM) signal. That is, a PWM signal transmitted by the converter controller 130 may be connected to a gate (or base) of the switching element Q1 so that the switching element Q1 may perform a switching operation by this PWM signal.

The converter controller 130 may include a gate driver for transmitting the PWM signal to the gate of the switching element Q1 and a controller for transmitting a driving signal to the gate driver.

The switching element Q1 may use a power transistor, for example, an insulated-gate bipolar transistor (IGBT).

The IGBT is a switching element having structures of a power metal oxide semiconductor field effect transistor (MOSFET) and a bipolar transistor and may achieve small driving power, high-speed switching, a high breakdown voltage, and high current density.

Thus, the converter controller 130 may control a turn-on time of the switching element Q1 in the converter 120. Then, the converter controller 130 may output a converter control signal Sc for controlling the turn-on time of the switching element Q1.

To this end, the converter controller 130 may receive an input voltage Vs and an input current Is from the input voltage detector A and the input current detector D, respectively.

In some cases, the converter 120 and the converter controller 130 may be omitted. That is, an output voltage passing through the rectifier 110 may be charged in the DC-link capacitor C or may drive the inverter 140, without passing through the converter 120.

The input voltage detector A may detect the input voltage Vs from the input AC power supply 10. For example, the input voltage detector A may be located in front of the rectifier 110.

To detect the input voltage Vs, the input voltage detector A may include a resistor, an operational amplifier (OP AMP), and the like. The detected input voltage Vs, which is a discrete signal of a pulse form, may be applied to the converter controller 130 in order to generate the converter control signal Sc.

Next, the input current detector D may detect the input current Is from the input AC power supply 10. Specifically, the input current detector D may be located in front of the rectifier 110.

To detect the input current Is, the input current detector D may include a current sensor, a current transformer (CT), a shunt resistor, and the like. The detected input voltage Is, which is a discrete signal of a pulse form, may be applied to the converter controller 130 in order to generate the converter control signal Sc.

The DC voltage detector B detects a DC voltage Vdc having a ripple component of the DC-link capacitor C. To detect the ripple voltage Vdc, the DC voltage detector B may include a resistor, an OP AMP, and the like. The detected voltage Vdc of the DC-link capacitor C, which is a discrete signal of a pulse type, may be applied to the inverter controller 150. The inverter controller 150 may generate an inverter control signal Si based on the DC voltage Vdc of the DC-link capacitor C.

Meanwhile, unlike FIG. 2, the detected DC voltage may be applied to the converter controller 130 so as to be used to generate the converter control signal Sc.

The inverter 140 includes a plurality of inverter switching elements Qa, Qb, Qc, Qa', Qb', and Qc'. The inverter 140 may convert a DC power voltage Vdc, which is smoothed by an on/off operation of the switching element Q1 of the converter 120, into a three-phase AC power voltage of a predetermined frequency and output the three-phase AC power voltage to the three-phase motor 200.

Specifically, in the inverter 140, the serially connected upper and lower switching elements Qa and Qa', Qb and Qb', and Qc and Qc' are paired and a total of three pairs of the upper and lower switching elements may be connected in parallel.

Like the converter 120, the switching elements Qa, Qb, Qc, Qa', Qb', and Qc' of the inverter 140 may use power transistors, for example, IGBTs.

To control a switching operation of the inverter 140, the inverter controller 150 may output the inverter control signal Si to the inverter 140. The inverter control signal Si is a switching control signal of a PWM scheme and may be generated based on an output current io flowing into the motor 200 and the DC-link voltage Vdc of both terminals of the DC-link capacitor C. In this case, the output current io may be detected by the output current detector E and the DC-link voltage Vdc may be detected by the DC-link voltage detector B.

The inverter controller 150 may include a gate driver 155 for transmitting a PWM signal to gates of the switching elements Qa, Qb, Qc, Qa', Qb', and Qc' of the inverter 140 and a controller 156 for transmitting a driving signal to the gate driver 155.

The output current detector E may detect the output current io flowing between the inverter 140 and the motor 200. That is, the output current detector E detects current flowing into the motor 200. The output current detector E may detect all output currents ia, ib, and ic of all phases or may detect output currents of two phases using three-phase equilibrium.

The output current detector E may be located between the inverter 140 and the motor 200 and may use a CT, a shunt resistor, etc. to detect current.

FIG. 3 is a circuit diagram illustrating the power conversion apparatus according to an embodiment of the present invention in detail.

Referring to FIG. 3, an enlarged configuration between the DC-link capacitor C and the inverter 140 in the power conversion apparatus is mainly illustrated.

That is, the power conversion apparatus of FIG. 3 may include the inverter 140 including a plurality of switching elements Qa, Qb, Qc, Qa', Qb', and Qc' corresponding to three phases, the gate driver 155 for driving the switching elements Qa, Qb, Qc, Qa', Qb', and Qc' of the inverter 140, and a noise reducer 160 connected to the gate driver 155, for setting switching noise occurrence times caused by the switching elements Qa, Qb, Qc, Qa', Qb', and Qc' in corresponding phases to be different.

In this case, the gate driver 155 may include a first driver 151 for driving the switching element Qa of a U-phase upper arm IN_UH, a second driver 152 for driving the switching element Qb of a V-phase upper arm IN_VH, a third driver 153 for driving the switching element Qc of a W-phase upper arm IN_WH, and a fourth driver 1544 for driving the switching elements Qa', Qb', and Qc' of U-phase, V-phase, and W-phase lower arms IN_UL, IN VL, and IN_WL.

The gate driver 155 including the first driver 151, the second driver 152, the third driver 153, and the fourth driver 154 may be connected to the controller 156 (refer to FIG. 2) through the noise reducer 160.

As illustrated in FIG. 3, the noise reducer 160 includes a plurality of resistor-capacitor (RC) filters R1/C1, R2/C2, R3/C3, R4/C4, R5/C5, and R6/C6, each of which is connected to a corresponding phase. At least two RC filters among the plurality of RC filters R1/C1, R2/C2, R3/C3, R4/C4, R5/C5, and R6/C6 have different time constant values.

The noise reducer 160 causes at least two of the switching elements Qa, Qb, Qc, Qa', Qb', and Qc' to generate different on/off times. Accordingly, overlapping of damping voltages is dispersed due to the different on/off time and electromagnetic interference (EMI) may be reduced. This effect will be described later in detail.

The noise reducer 160 is located in front of the gate driver 155 and may be implemented using an RC filter circuit for eliminating noise. That is, the noise reducer 160 may include a filter circuit.

In such an RC filter circuit, the resistors R1, R2, R3, R4, R5, and R6 and the capacitors C1, C2, C3, C4, C5, and C6 are connected to respective terminals of three phases to prevent the switching elements Qa, Qb, Qc, Qa', Qb', and Qc' from operating by noise rather than a PWM signal.

Terminals IN_WH, IN_VH, IN_UH, IN_UL, IN VL, and IN_WL to which signals from the controller 156 are input may be located at an input side of the noise reducer 160 implemented using the RC filter circuit. That is, the control signal input from the controller 156 may be transmitted to the gate driver 155 after passing through the noise reducer 160.

In some cases, the RC filters R1/C1, R2/C2, and R3/C3 connected to the upper switching elements Qa, Qb, and Qc of the respective phases and the RC filters R4/C4, R5/C5, and R6/C6 connected to the lower switching elements Qa', Qb', and Qc' of the respective phases may be treated separately.

That is, the noise reducer 160 may set switching noise occurrence times caused by the upper switching elements Qa, Qb, and Qc of the respective phases to be different.

Meanwhile, the RC filters R1/C1, R2/C2, and R3/C3 connected to the upper switching elements Qa, Qb, and Qc of the respective phases and the RC filters R4/C4, R5/C5, and R6/C6 connected to the lower switching elements Qa', Qb', and Qc' of the respective phases may have a common value.

That is, the RC filters connected to each phase may have the same time constant value. For example, the RC filters R1/C1 and R4/C4 connected to a U phase may have the same time constant value. Similarly, RC filters R2/C2 and R5/C5 connected to a V phase may have the same time constant value and the RC filters R3/C3 and R6/C6 connected to a W phase may have the same time constant.

Alternatively, switching noise occurrence times caused by the lower switching elements Qa', Qb', and Qc' of the respective phases may be set to be different.

Switching noise of the switching elements Qa, Qb, Qc, Qa', Qb', and Qc' may be generated in the process when the switching elements Qa, Qb, Qc, Qa', Qb', and Qc' are switched on/off.

In this way, the noise reducer 160 may set on/off times of the switching elements Qa, Qb, Qc, Qa', Qb', and Qc' to be different.

That is, the switching noise occurrence times may be equal to or overlap with respective on/off operation times of the switching elements.

As an example, all of the RC filters R1/C1, R2/C2, R3/C3, R4/C4, R5/C5, and R6/C6, each of which is connected to a corresponding phase, may have different time constant values.

As another example, all of the RC filters R1/C1, R2/C2, and R3/C3 connected to the upper switching elements Qa, Qb, and Qc of the respective phases may have different time constant values.

Alternatively, all of the RC filters R4/C4, R5/C5, and R6/C6 connected to the lower switching elements Qa', Qb', and Qc' of the respective phases may have different time constant values.

As described above, the RC filters R1/C1, R2/C2, R3/C3 connected to the upper switching elements Qa, Qb, and Qc and the RC filters R4/C4, R5/C5, and R6/C6 connected to the lower switching elements Qa', Qb', and Qc' may be treated separately.

Hereinafter, three phases for generating three-phase AC signals will be referred to as a U phase, a V phase, and a W phase. In the case of the inverter, the noise reducer 160 will be described in relation to an RC filter and a switching element of each of the phases (U phase, V phase, and W phase). A description of the noise reducer 160 for each phase may be separately applied to the upper switching elements Qa, Qb, and Qc and the lower switching elements Qa', Qb', and Qc' or may be applied to either the upper switching elements Qa, Qb, and Qc or the lower switching elements Qa', Qb', and Qc'.

Time constant values of the plurality of RC filters R1/C1, R2/C2, R3/C3, R4/C4, R5/C5, and R6/C6 constituting the noise reducer 160 may be sequentially changed.

In addition, the time constant values may be sequentially increased from a reference value. Herein, the reference value may be a switching start time for normal PWM driving of the switching elements Qa, Qb, Qc, Qa', Qb', and Qc'.

The noise reducer 160 of the above-described configuration may set switching noise occurrence times of the switching elements Qa, Qb, Qc, Qa', Qb', and Qc' to be sequentially delayed in each phase.

In this case, the delayed time may be shorter than each of switching times of the switching elements Qa, Qb, Qc, Qa', Qb', and Qc'.

FIG. 4 is a waveform chart illustrating current when a normal filter circuit is applied and FIG. 5 is a waveform chart illustrating current when a noise reducer of the present invention is applied.

Referring to FIG. 4, a collector current Ic, which is a current applied to a switching element, is raised with a predetermined slope by an inductor component of the motor 200 but includes noise before the switching element is fully switched on. Such noise is caused by switching noise of the switching element.

In this case, all switching noise components occurring in respective phases overlap as illustrated in a signal of the lowermost waveform in FIG. 4. Thus, the noise components overlap and a peak appears. The noise peak may deteriorate an EMI characteristic.

However, as illustrated in FIG. 5 according to an embodiment of the present invention, a switching time on each phase is delayed by a and b.

For example, switching of a switching element on a U phase may be performed based on a reference switching time but may be delayed on a V phase by a predetermined delay time a. In addition, switching of the switching element on a W phase may be delayed by a predetermined delay time b. Herein, the delay time a on the V phase and the delay time b on the W phase are different.

Thus, on/off times of switching elements differ. Referring to the lowermost waveform of FIG. 5, noise components of respective phases are dispersed and EMI is reduced.

That is, overlapping of noise is avoided and a peak does not appear. Therefore, an EMI characteristic can be improved.

FIG. 6 is a waveform chart illustrating current and voltage waveforms of a switching element and FIG. 7 is a waveform chart illustrating a process of designing a time constant of a noise reducer of the present invention.

Referring to FIG. 6, in the case that an IGBT switching element is used, a time consumed to switch the switching element from an on time is about 160 to 180 ns. Accordingly, a delay time of a switching time of the switching element may be set to be shorter than 160 to 180 ns. For example, the delay time may be set to about 100 ns or so. That is, the delay time may be set to 80 to 120 ns.

While the delay time of the switching time may be changed according to design concept, the delay time may be shorter than the switching time.

In FIG. 6, a description will now be given focusing on a collector current Ic. In FIG. 6, tr denotes a time consumed to raise current from 10% to 90% and trr denotes a time consumed to stabilize current from 90% to 100%. It can be appreciated that noise occurs during the time trr.

In addition, td(on) denotes a time consumed to raise current up to 10% after a PWM high signal is applied and ton denotes a time consumed to raise current up to 90% after the PWM high signal is applied.

Similarly, tf denotes a time taken when current is lowered and may have the same meaning as the above description except for a lowering direction.

A process of configuring the noise reducer 160 by constructing an RC filter circuit in which a delay time of an on time of a switching element is set to 100 ns will now be described with reference to FIG. 7. Herein, the delay time may correspond to at least one of the delay times a and b of FIG. 5.

First, an RC filter is selected as a reference value according to a recommend value of a data sheet of a used inverter module. For example, a resistor of 100 Ω and a capacitor of 1 nF may be selected.

Next, a rising time up to an operating voltage of 2 V of a gate driver of the inverter module is calculated.

The rising time may be calculated as 51.1 ns by Equation 1.

[Equation 1]

$$V = E(1 - e^{-\frac{t}{RC}})$$

In this case, E is a voltage value of a normal state and RC denotes an RC time constant.

Next, a resistance satisfying a condition in which the rising time up to the operation voltage of 2 V becomes 151.1 ns obtained by adding the rising time calculated above to a delay time of 100 ns is calculated.

Then, the resistance may be calculated as 300 Ω. That is, an RC filter to which the delay time is applied may select a resistor of 300 Ω and a capacitor of 1 nF.

In the same way, a resistance satisfying a condition in which a rising time up to the operation voltage of 2 V becomes 251.1 ns may be calculated and then an RC filter to which the calculated resistance value is applied may be selected.

Through the above process, the noise reducer 160 capable of being implemented using an RC filter considering a relay time may be configured.

FIG. 8 is a waveform chart illustrating a phase current caused by an inverter and an enlarged view thereof.

(a) of FIG. 8 illustrates a phase current caused by an inverter and (b) of FIG. 8 is an enlarged view of a part d in (a) of FIG. 8.

As illustrated in (b) of FIG. 8, the phase current includes substantial noise.

(c) of FIG. 8 is an enlarged vies of a part e in (b) of FIG. 8. Referring to (c) of FIG. 8, one noise peak includes a part f caused by switching noise and a part g in which a slope is changed by inductance of a motor.

FIG. 9 is a waveform chart illustrating actual switching noise of a phase current. It can be appreciated that many switching noise components f appear periodically.

According to an embodiment of the present invention, since the magnitude of the part f caused by switching noise can be significantly improved, entire switching noise can be reduced and thus an EMI characteristic can be improved.

In addition, since overlapping of noise components is avoided, a peak does not appear in noise and the EMI characteristic can be improved.

It will be apparent to those skilled in the art that various modifications and variations can be made in the present invention without departing from the scope of the inventions. Thus, it is intended that the present invention cover the modifications and variations of this invention provided they come within the scope of the appended claims.

## Claims

**1.** A power conversion apparatus, comprising:

an inverter (140) including a plurality of switching elements (Qa, Qb, Qc, Qa', Qb', Qc') corresponding to three phases including a first phase, a second phase and a third phase;
a gate driver (155) configured to drive the switching elements (Qa, Qb, Qc, Qa', Qb', Qc') of the inverter (140);
a controller (156) configured to transmit a control signal to the gate driver; and
a noise reducer (160) connected to the gate driver (155) and configured to set switching noise occurrence times caused by the switching elements in the respective phases to be different,
**characterized in that**
the noise reducer (160) includes resistor-capacitor , RC, filters connected to respective switching elements in the respective phases and at least two of the RC filters have different time constant values such that switching of a switching element on the first phase is performed based on a reference switching time but delayed on the second phase by a predetermined delay time 'a', and switching of a switching element on the third phase is delayed by a predetermined delay time 'b' that differs from the delay time 'a',
wherein the noise reducer (160) is connected between the gate driver (155) and the controller (156), wherein the time constant values are sequentially changed.

**2.** The power conversion apparatus according to claim 1, wherein the control signal input from the controller (156) is transmitted to the gate driver (155) after passing through the noise reducer (160) and switching of the switching element on the second phase is delayed.

**3.** The power conversion apparatus according to claim 1 or 2, wherein the time constant values are sequentially increased from a reference value.

**4.** The power conversion apparatus according to any one of claims 1 to 3, wherein the noise reducer (160) includes a filter circuit configured to reduce noise of the control signal transmitted to the gate driver (155).

**5.** The power conversion apparatus according to any one of claims 1 to 4, wherein the noise reducer (160) sets on times of the switching elements to be different.

**6.** The power conversion apparatus according to any one of claims 1 to 5, wherein the noise reducer (160) sets the switching noise occurrence times to be sequentially delayed in the respective phases.

**7.** The power conversion apparatus according to claim 6, wherein the delayed times are shorter than switching times of the switching elements.

**8.** The power conversion apparatus according to any one of claims 1 to 7, wherein the plurality of switching elements includes upper switching elements (Qa, Qb, and Qc) and lower switching elements (Qa', Qb', and Qc').

**9.** The power conversion apparatus according to claim 8, wherein RC filters (R1/C1, R2/C2, and R3/C3)

connected to the upper switching elements (Qa, Qb, and Qc) of a respective phase and the RC filters (R4/C4, R5/C5, and R6/C6) connected to the lower switching elements (Qa', Qb', and Qc') of the respective phase have a common value.

**10.** The power conversion apparatus according to claim 8 or 9, wherein the noise reducer (160) is connected to either one of the upper switching elements (Qa, Qb, and Qc) or the lower switching elements (Qa', Qb', and Qc').

**11.** The power conversion apparatus according to any one of claims 1 to 10, wherein the time constant values for the three phases are sequentially changed from a reference value, which is corresponding to the time constant value for the first phase.

**12.** The power conversion apparatus according to any one of claims 1 to 11, wherein the delay time is shorter than the reference switching time.

## Patentansprüche

**1.** Leistungsumwandlungsvorrichtung, die aufweist:

einen Inverter (140), der mehrere Schaltelemente (Qa, Qb, Qc, Qa', Qb', Qc'), die drei Phasen einschließlich einer ersten Phase, einer zweiten Phase und einer dritten Phase entsprechen, aufweist;
einen Gate-Treiber (155), der konfiguriert ist, um die Schaltelemente (Qa, Qb, Qc, Qa', Qb', Qc') des Inverters (140) anzusteuern;
eine Steuerung (156), die konfiguriert ist, um ein Steuersignal an den Gate-Treiber zu übertragen; und
einen Störbegrenzer (160), der mit dem Gate-Treiber (155) verbunden ist und konfiguriert ist, um Schaltstörungsauftrittszeiten, die durch die Schaltelemente in den jeweiligen Phasen bewirkt werden, unterschiedlich festzulegen, **dadurch gekennzeichnet, dass**
der Störbegrenzer (160) Widerstands-Kondensator-, RC-, Filter aufweist, die mit jeweiligen Schaltelementen in den zwei jeweiligen Phasen verbunden sind, und wobei wenigstens zwei der RC-Filter unterschiedliche Zeitkonstantenwerte haben, so dass das Schalten eines Schaltelements auf der ersten Phase basierend auf einer Referenzschaltzeit, aber auf der zweiten Phase um eine vorbestimmte Verzögerungszeit ,a' verzögert durchgeführt wird und das Schalten eines Schaltelements auf der dritten Phase um eine vorbestimmte Zeit ,b', die sich von der Verzögerungszeit ,a' unterscheidet, verzögert wird,
wobei der Störbegrenzer (160) zwischen den Gate-Treiber (155) und die Steuerung (156) geschaltet ist, wobei die Zeitkonstantenwerte nacheinander geändert werden.

**2.** Leistungsumwandlungsvorrichtung nach Anspruch 1, wobei das von der Steuerung (156) eingespeiste Steuersignal an den Gate-Treiber (155) übertragen wird, nachdem es den Störbegrenzer (160) durchlaufen hat und das Schalten des Schaltelements auf der zweiten Phase verzögert wurde.

**3.** Leistungsumwandlungsvorrichtung nach Anspruch 1 oder 2, wobei die Zeitkonstantenwerte von einem Referenzwert nacheinander erhöht werden.

**4.** Leistungsumwandlungsvorrichtung nach einem der Ansprüche 1 bis 3, wobei der Störbegrenzer (160) eine Filterschaltung aufweist, die konfiguriert ist, um Störungen des an den Gate-Treiber (155) übertragenen Steuersignals zu verringern.

**5.** Leistungsumwandlungsvorrichtung nach einem der Ansprüche 1 bis 4, wobei der Störbegrenzer (160) Zeiten der Schaltelemente unterschiedlich festlegt.

**6.** Leistungsumwandlungsvorrichtung nach einem der Ansprüche 1 bis 5, wobei der Störbegrenzer (160) die Schaltstörungsauftrittszeiten derart festlegt, dass sie in den jeweiligen Phasen nacheinander verzögert werden.

**7.** Leistungsumwandlungsvorrichtung nach Anspruch 6, wobei die Verzögerungszeiten kürzer als die Schaltzeiten der Schaltelemente sind.

**8.** Leistungsumwandlungsvorrichtung nach einem der Ansprüche 1 bis 7, wobei die mehreren Schaltelemente obere Schaltelemente (Qa, Qb und Qc) und untere Schaltelemente (Qa', Qb' und Qc') umfassen.

**9.** Leistungsumwandlungsvorrichtung nach Anspruch 8, wobei RC-Filter (R1/C1, R2/C2 und R3/C3), die mit den oberen Schaltelementen (Qa, Qb und Qc) einer jeweiligen Phase verbunden sind, und die RC-Filter (R4/C4, R5/C5 und R6/C6), die mit den unteren Schaltelementen (Qa', Qb' und Qc') der jeweiligen Phase verbunden sind, einen gemeinsamen Wert haben.

**10.** Leistungsumwandlungsvorrichtung nach Anspruch 8 oder 9, wobei der Störbegrenzer (160) mit einem der oberen Schaltelemente (Qa, Qb und Qc) oder der unteren Schaltelemente (Qa', Qb' und Qc') verbunden ist.

**11.** Leistungsumwandlungsvorrichtung nach einem der Ansprüche 1 bis 10, wobei die Zeitkonstantenwerte für die drei Phasen von einem Referenzwert, der dem Zeitkonstantenwert für die erste Phase entspricht, nacheinander geändert werden.

**12.** Leistungsumwandlungsvorrichtung nach einem der Ansprüche 1 bis 11, wobei die Verzögerungszeit kürzer als die Referenzschaltzeit ist.

## Revendications

**1.** Appareil de conversion de puissance, comprenant :

un onduleur (140) incluant une pluralité d'éléments de commutation (Qa, Qb, Qc, Qa', Qb', Qc') correspondant à trois phases incluant une première phase, une deuxième phase et une troisième phase ;
un circuit d'attaque de grille (155) configuré pour piloter les éléments de commutation (Qa, Qb, Qc, Qa', Qb', Qc') de l'onduleur (140) ;
un contrôleur (156) configuré pour transmettre un signal de commande au circuit d'attaque de grille ; et
un réducteur de bruit (160) connecté au circuit d'attaque de grille (155) et configuré pour régler des temps d'occurrence de bruit de commutation provoqués par les éléments de commutation dans les phases respectives afin qu'ils soient différents, **caractérisé en ce que**
le réducteur de bruit (160) inclut des filtres « résistance-condensateur », RC, connectés à des éléments de commutation respectifs dans les phases respectives, et au moins deux des filtres RC ont des valeurs de constante de temps différentes, de sorte que la commutation d'un élément de commutation sur la première phase soit réalisée sur la base d'un temps de commutation de référence, mais est retardée sur la deuxième phase d'un temps de retard prédéterminé 'a', et la commutation d'un élément de commutation sur la troisième phase est retardée d'un temps de retard prédéterminé 'b' qui diffère du temps de retard 'a' ;
dans lequel le réducteur de bruit (160) est connecté entre le circuit d'attaque de grille (155) et le contrôleur (156), et dans lequel les valeurs de constante de temps sont modifiées séquentiellement.

**2.** Appareil de conversion de puissance selon la revendication 1, dans lequel le signal de commande appliqué en entrée à partir du contrôleur (156) est transmis au circuit d'attaque de grille (155) après avoir transité par le réducteur de bruit (160), et la commutation de l'élément de commutation sur la deuxième phase est retardée.

**3.** Appareil de conversion de puissance selon la revendication 1 ou 2, dans lequel les valeurs de constante de temps sont augmentées séquentiellement à partir d'une valeur de référence.

**4.** Appareil de conversion de puissance selon l'une quelconque des revendications 1 à 3, dans lequel le réducteur de bruit (160) inclut un circuit de filtrage configuré pour réduire du bruit du signal de commande transmis au circuit d'attaque de grille (155).

**5.** Appareil de conversion de puissance selon l'une quelconque des revendications 1 à 4, dans lequel le réducteur de bruit (160) règle des temps d'activation des éléments de commutation afin qu'ils soient différents.

**6.** Appareil de conversion de puissance selon l'une quelconque des revendications 1 à 5, dans lequel le réducteur de bruit (160) règle les temps d'occurrence de bruit de commutation afin qu'ils soient retardés séquentiellement dans les phases respectives.

**7.** Appareil de conversion de puissance selon la revendication 6, dans lequel les temps retardés sont plus courts que des temps de commutation des éléments de commutation.

**8.** Appareil de conversion de puissance selon l'une quelconque des revendications 1 à 7, dans lequel la pluralité d'éléments de commutation inclut des éléments de commutation supérieurs (Qa, Qb et Qc) et des éléments de commutation inférieurs (Qa', Qb' et Qc').

**9.** Appareil de conversion de puissance selon la revendication 8, dans lequel les filtres RC (R1/C1, R2/C2, et R3/C3) connectés aux éléments de commutation supérieurs (Qa, Qb, et Qc) d'une phase respective, et les filtres RC (R4/C4, R5/C5, et R6/C6) connectés aux éléments de commutation inférieurs (Qa', Qb', et Qc') de la phase respective présentent une valeur commune.

**10.** Appareil de conversion de puissance selon la revendication 8 ou 9, dans lequel le réducteur de bruit (160) est connecté à l'un ou l'autre des éléments de commutation supérieurs (Qa, Qb et Qc) ou des éléments de commutation inférieurs (Qa', Qb' et Qc').

**11.** Appareil de conversion de puissance selon l'une quelconque des revendications 1 à 10, dans lequel les valeurs de constante de temps pour les trois phases sont modifiées séquentiellement à partir d'une valeur de référence, laquelle correspond à la valeur de constante de temps pour la première phase.

**12.** Appareil de conversion de puissance selon l'une quelconque des revendications 1 à 11, dans lequel le temps de retard est plus court que le temps de commutation de référence.

FIG. 1

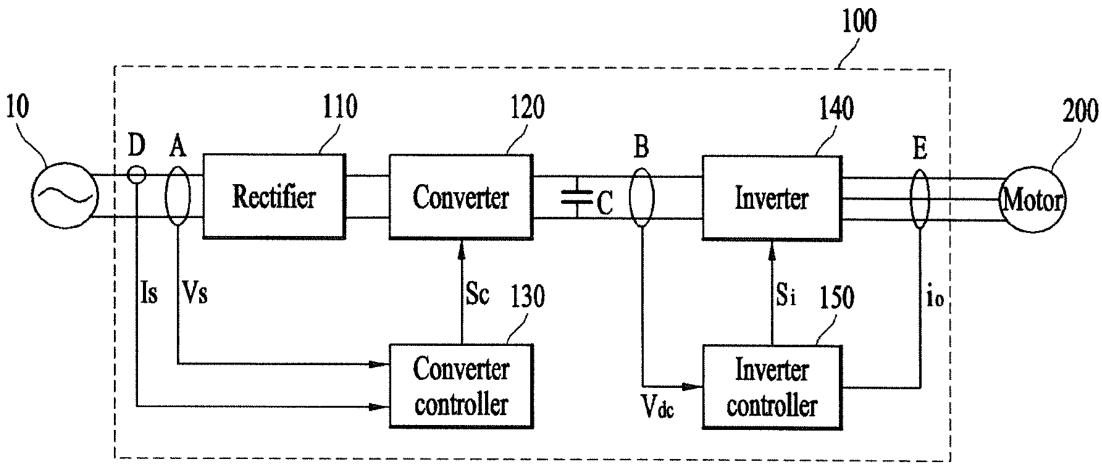
100
10
110
120
140
200
D
A
B
E
Rectifier
Converter
C
Inverter
Motor
Is
Vs
Sc
130
Si
150
io
Converter controller
Vdc
Inverter controller

FIG. 2

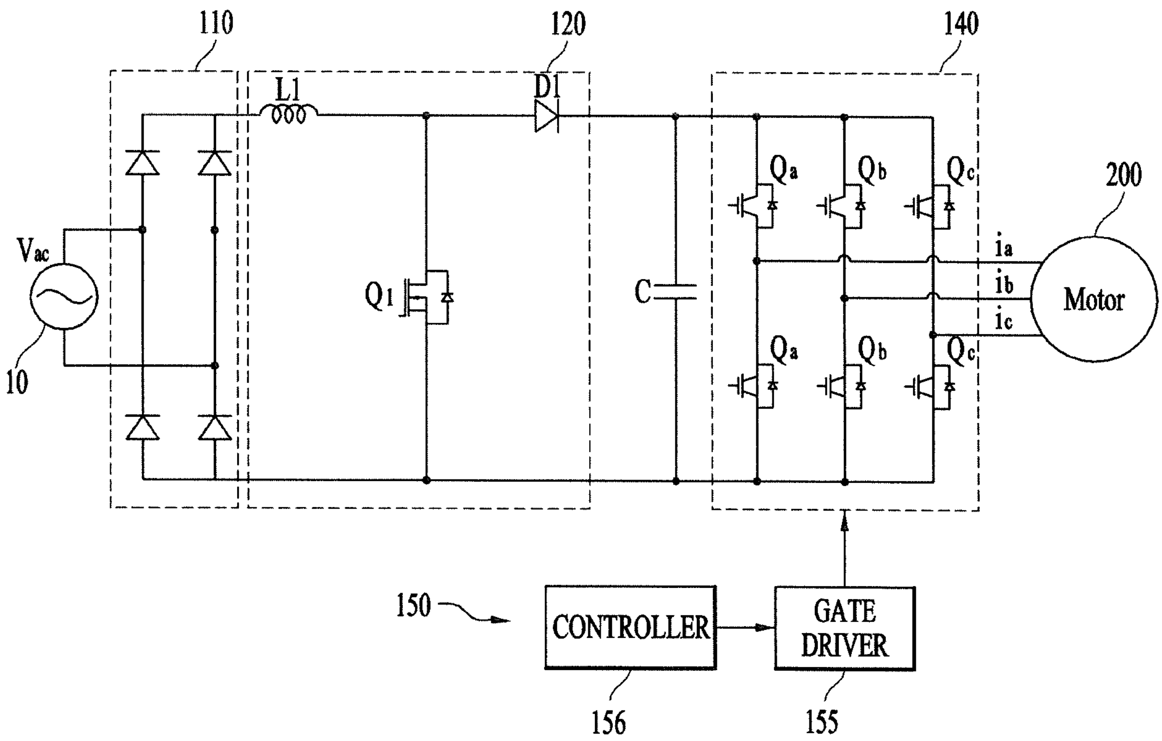
110
120
140
L1
D1
Qa
Qb
Qc
200
Vac
ia
ib
ic
Q1
C
Motor
10
150
CONTROLLER
GATE DRIVER
156
155

FIG. 3

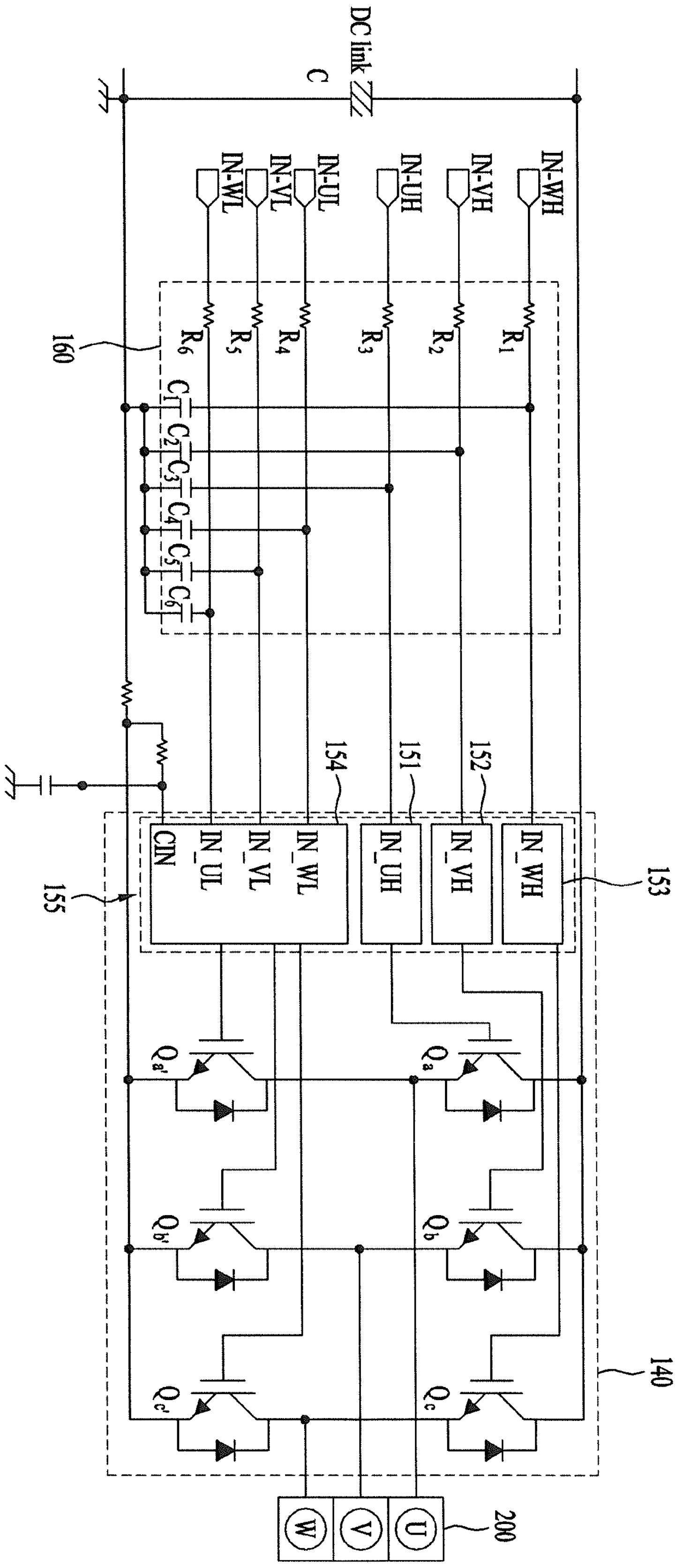
DC link
C
IN-WH
IN-VH
IN-UH
IN-UL
IN-VL
IN-WL
$R_1$
$R_2$
$R_3$
$R_4$
$R_5$
$R_6$
$C_1$
$C_2$
$C_3$
$C_4$
$C_5$
$C_6$
160
154
151
152
153
155
CIN
IN_UL
IN_VL
IN_WL
IN_UH
IN_VH
IN_WH
$Q_a$
$Q_b$
$Q_c$
$Q_{a'}$
$Q_{b'}$
$Q_{c'}$
140
U
V
W
200

FIG. 4

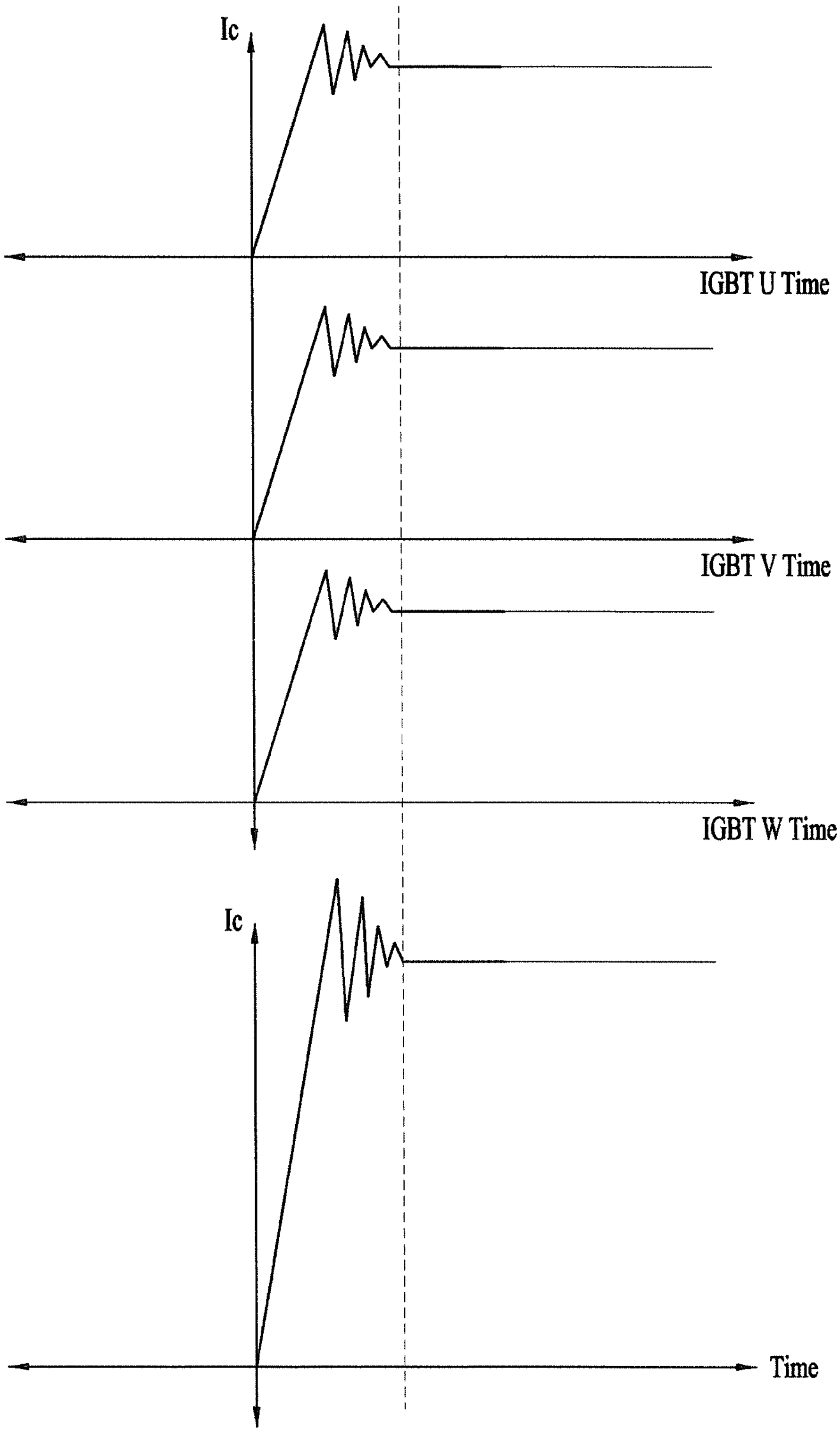

FIG. 5

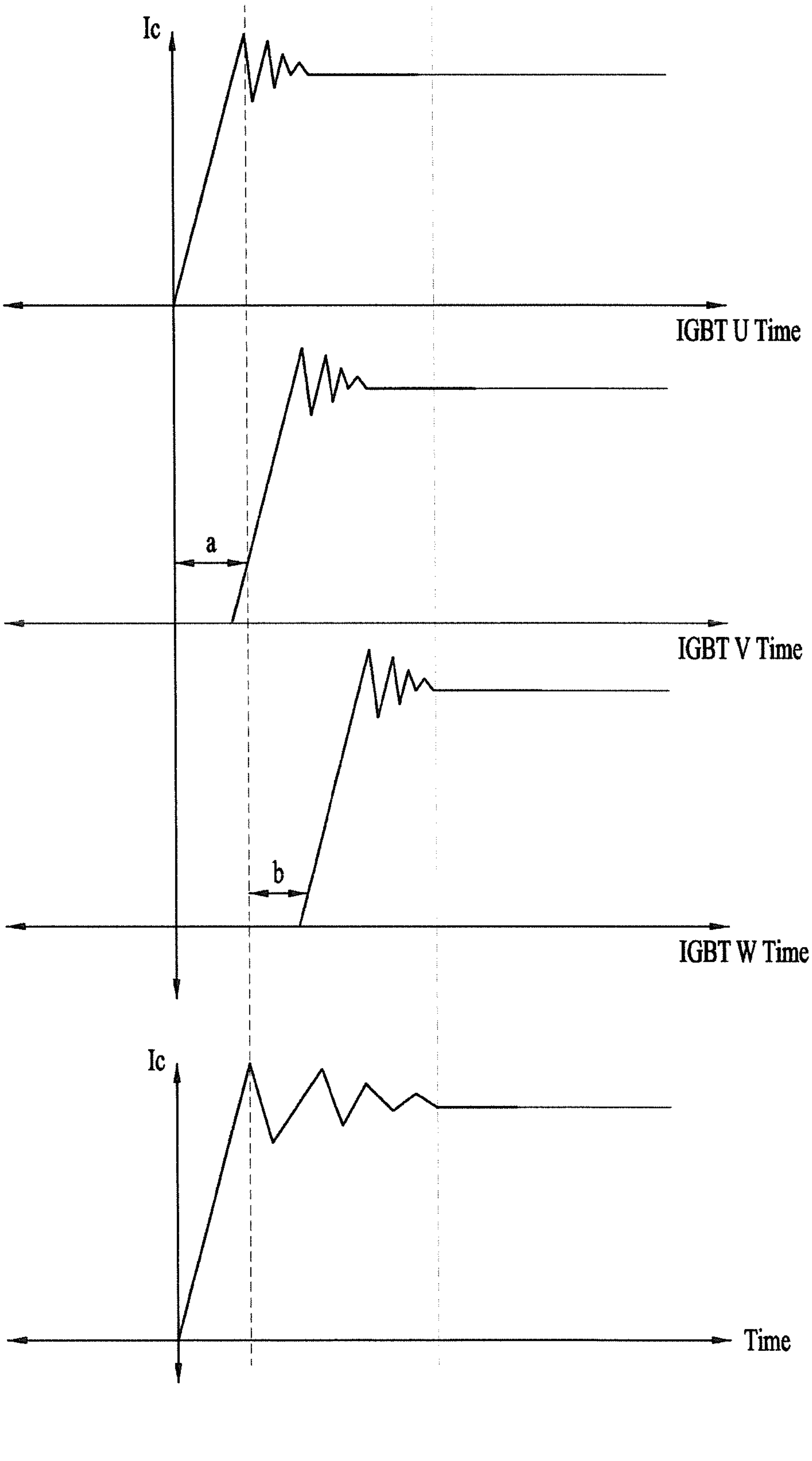

FIG. 6

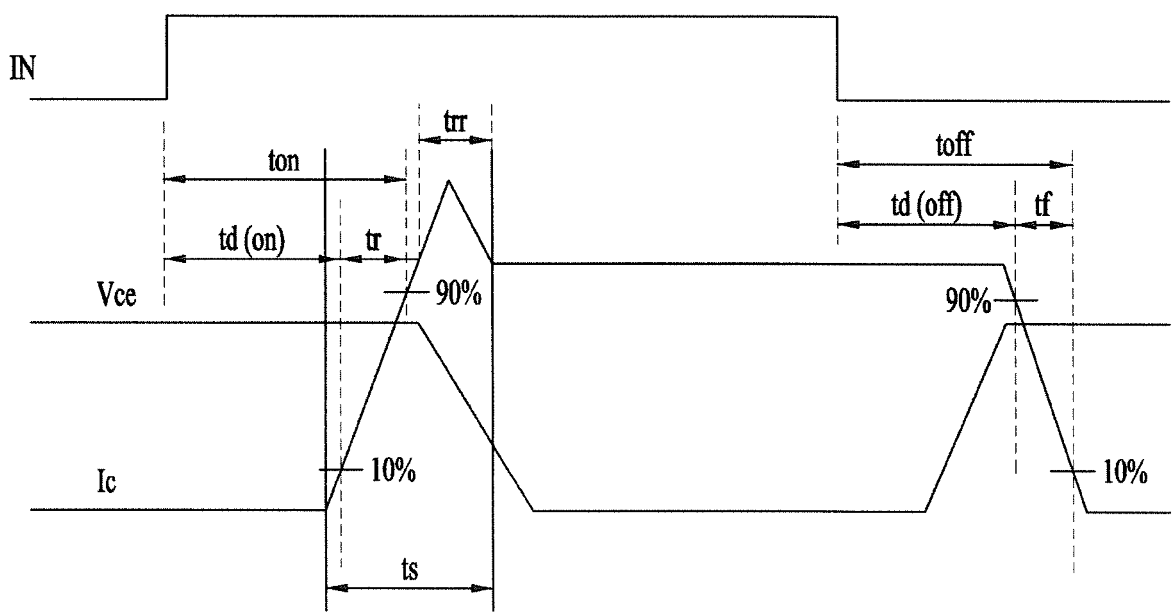

FIG. 7

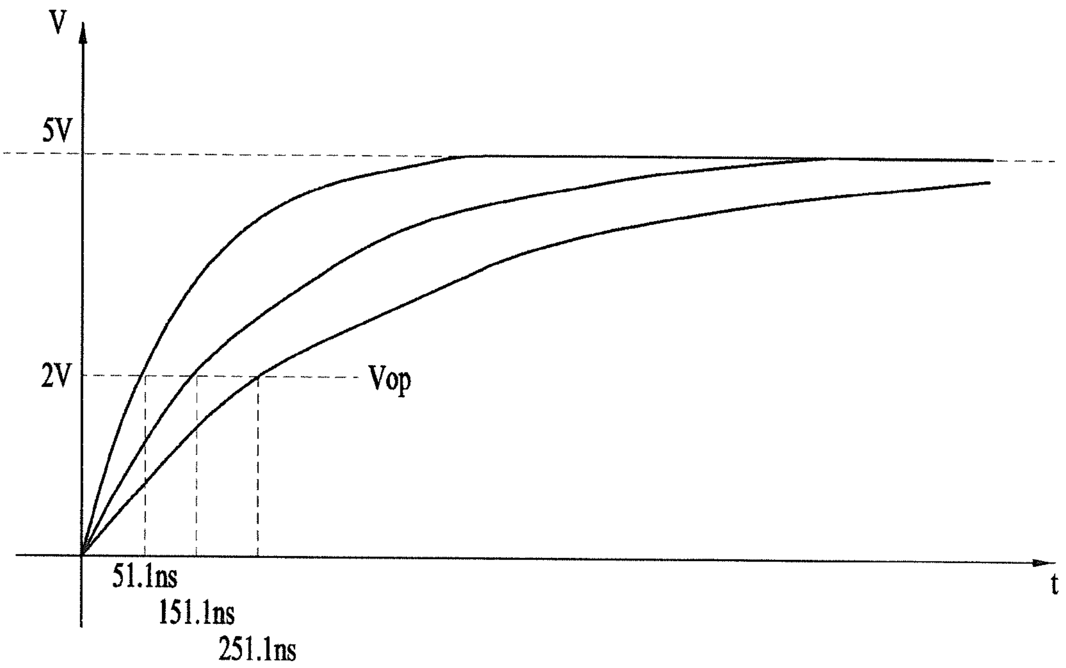

FIG. 8

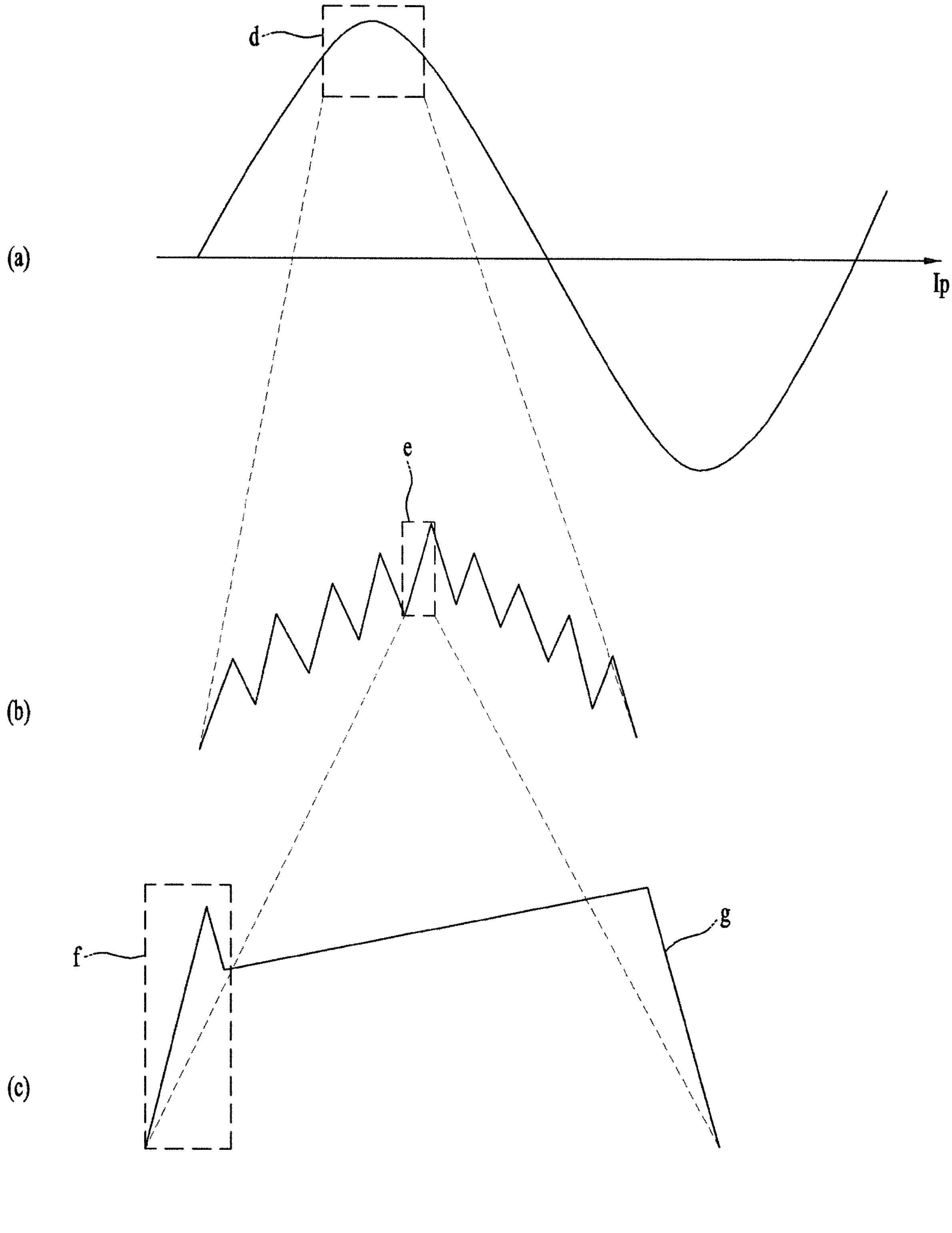

FIG. 9

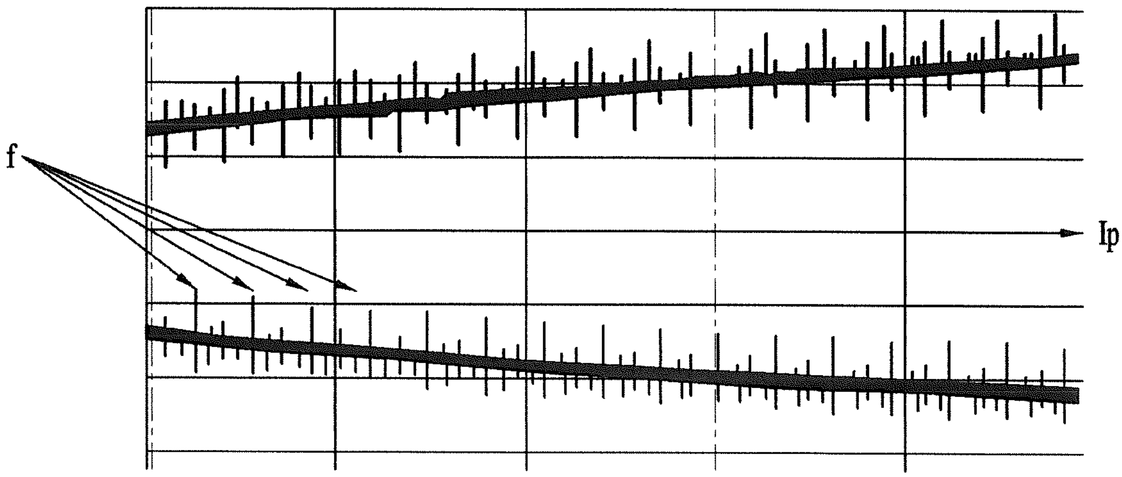

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2014036539 A
- JP 2005051959 A